# EUROPEAN PATENT SPECIFICATION

(11) **EP 0 543 835 B1**
(45) Date of publication and mention of the grant of the patent: **28.05.1997**
(21) Application number: 91913022.9
(22) Date of filing: 24.07.1991
(51) Int. Cl.: G01R 27/28, G01R 27/06

(54) **METHOD AND DEVICE FOR SUPERVISING THE CONDITION OF A RECEIVING ANTENNA**
VERFAHREN UND VORRICHTUNG ZUR ÜBERWACHUNG DES ZUSTANDEN EINER EMPFANGSANTENNE
PROCEDE ET DISPOSITIF DE CONTROLE DE L'ETAT D'UNE ANTENNE RECEPTRICE

(30) Priority: 17.08.1990 FI 904085
(43) Date of publication of application: 02.06.1993
(73) Proprietor: NOKIA TELECOMMUNICATIONS OY, 02601 Espoo (FI)
(72) Inventor: SAVUSALO, Jari, SF-90500 Oulu (FI); JÄNTTI, Arto, SF-90630 Oulu (FI)
(74) Representative: Tomlinson, Kerry John
(86) International application number: FI9100227
(87) International publication number: WO9203744

(56) References cited:
- EP-A- 0 261 828
- DE-A- 3 317 358
- US-A- 4 962 359

## Description

The invention relates to a method of supervising the condition of a receiving antenna by transmitting a radio-frequency measuring signal through an antenna line to the antenna and by measuring the magnitude of a measuring signal component reflected back from the antenna over a predetermined measuring path.

Receiving and transmitting antennas form an essential part of radio systems, such as cellular radio telephone systems and their base stations, and their condition affects the quality of transmissions. The condition of the antennas can be supervised e.g. by measuring their standing-wave ratio, that is, the electric matching of the antennas to the rest of the receiving and transmitting system.

With methods in use today, the measurement is carried out by supplying power to the receiving antenna through the antenna line and by measuring the power reflected from the antenna through the antenna line by means of a wideband powermeter. Due to the wide bandwidth of the powermeter, high power has to be used in the measurement in order that the measurement would not be sensitive to interferences, that is, signals received by the antenna would not interfere with the measurement. The use of high power causes intermodulation distortion in the receiver. Such problems can be avoided by using a duplex filter which separates the measuring signal and the signals to be received from each other. The duplex filter, however, has to precede the receiver parts, which deteriorates the sensitivity of the receiver as the filter causes losses in the antenna signal.

In one prior art arrangement, both of the above-mentioned problems are avoided by using a measuring frequency outside the receiving band and a narrow-band power measurement matched to this frequency.

EP Patent Application 0 261 828 discloses a microwave range analyser in which both a signal supplied directly from the measuring source and a signal reflected from a microwave network under analysis is measured for a vector-based relative power measurement. In the measurement of the reflected power, a sample signal extracted from the output power of the measuring signal generator is applied to a detector over a different path from that of a sample signal extracted from the power reflected from the microwave network under analysis. Thus, in the EP Application, the relative measurement is rather insensitive to variation in the output level of the measuring signal generator, but as the signals to be compared with each other propagate over different paths to the detector, the measurement does not automatically take into account imperfections and variations occurring in the properties of signal path components. For the measurement of reflected power the analyser has to be calibrated by first measuring a known microwave standard by it and using the calibration values so obtained in subsequent measurements. In the measurement of the condition of the antenna, this would imply that the antenna supply should be connected to a microwave standard in place of the antenna for calibration.

DE-A-3317358 describes a further prior art method and device for supervising the condition of an antenna. The preambles to the independent claims are based on that document.

The object of the invention is to improve the accuracy, reliability and long-term stability of prior methods intended for supervising the condition of the antenna.

This is achieved by means of the method of the present invention, which provides a method of supervising the condition of a receiving antenna, comprising the steps of generating a radio-frequency measuring signal, transmitting said radio-frequency measuring signal through an antenna line connected to the receiving antenna in the direction of the receiving antenna, measuring the magnitude of a measuring signal component reflected back from the receiving antenna and propagated over a predetermined measuring signal path, directly transmitting said radio-frequency measuring signal through the antenna line in the direction of the point of measurement, measuring a magnitude of said directly transmitted measuring signal, and determining the condition of the receiving antenna on the basis of a comparison of the two measured signal magnitudes, characterized in that: the predetermined measuring signal path is the path between the point on the antenna line from where said radio frequency signal is directly transmitted in the direction of the point of measurement and that point of measurement, and in that the step of measuring a magnitude of said directly transmitted measuring signal consists of measuring the magnitude of said directly transmitted measuring signal propagated over said measuring signal path, and in that the determination of the condition of the receiving antenna is based on the relative difference between the two measured signal magnitudes.

The invention is also concerned with a device for supervising the condition of a receiving antenna, comprising a generating means for generating a radio-frequency measuring signal, a first directional coupling means for applying the measuring signal to an antenna line connected to the receiving antenna in the direction of the receiving antenna, a second directional coupling means for applying the measuring signal directly in the direction of a measuring means, a measuring means for reflected from the antenna and propagated over a predetermined measuring signal path, and for measuring the magnitude of said directly transmitted measuring signal, and for determining the condition of the receiving antenna on the basis of a comparison of the two measured signal magnitudes, characterized in that the second directional coupling means is adapted to apply the measuring signal to the antenna line and in that the device comprises a switch means for switching the measuring signal from the generating means between the first directional coupling means and second directional coupling means, and in that the switch means, first directional coupling means, second directional coupling means, and the measuring means are arranged such that the directly transmitted measuring signal and the measuring signal component reflected from the antenna propagate over the same predetermined measuring signal path, and in that the predetermined measuring signal path is the path between the point on the antenna line where the second directional coupling means is connected to the antenna line and the measuring means, and in that the measuring means determines the condition of the receiving antenna on the basis of the relative difference between the two measured signal magnitudes.

The basic idea of the invention is to measure not only the signal reflected from the antenna but also separately the magnitude of the measuring signal transmitted directly in the direction of the receiver. This other measurement provides a reference value for the magnitude of the measuring signal, with which value the magnitude of the measuring signal component reflected from the antenna is compared. This reference value takes into account the transmission power of the measuring signal generator and the properties of signal path components, such as amplifiers and branching devices, at the measuring moment. With such a relative measurement the measuring accuracy is not affected by deviation occurring between the properties of different individual components forming part of the measuring arrangement and the measuring signal path or variation in time in the properties of one and the same component. By means of the invention, it is also possible to substantially reduce and simplify manual check-ups and calibrations during installation and use or even completely avoid them.

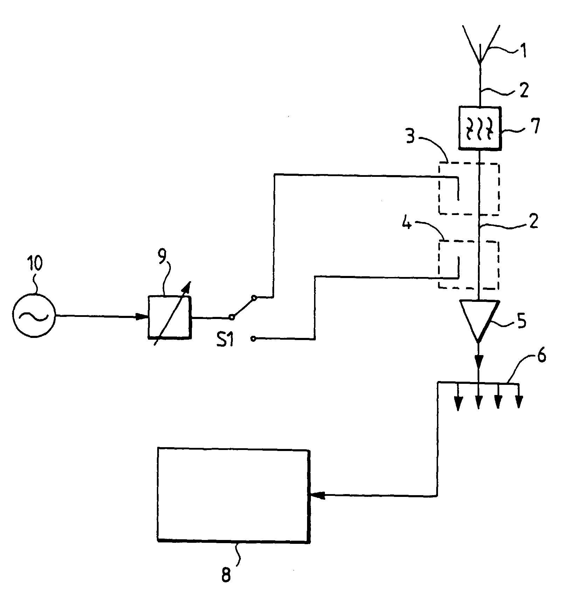

In the following the invention will be described in greater detail by means of exemplifying embodiments with reference to the attached figure, which shows a block diagram of a device realizing the method according to the invention.

The invention will be described herein only to such an extent as is necessary for the disclosure and understanding of the invention. A receiving antenna 1 is connected by means of an antenna cable 2 through a bandpass filter 7 and a dividing amplifier 5 to a branching device 6 which divides a signal coming from the direction of the antenna into two or more branches. The branching device 6 is used especially in radio systems comprisinq several frequency channels when each frequency c nnel has a separate receiver after the branching device.

A signal generator 9 generates a radio-frequency measuring signal for use in the measurement of the condition of the antenna. The frequency of the measuring signal is preferably outside the normal receiving band of the receiver so as to minimize interference occurring in normal reception. An adjustable attenuator or amplifier 9 may be connected to the output of the signal generator 10 for adjusting the magnitude of the measuring signal to be transmitted. The measuring signal is applied from the attenuator 9 to a change-over switch S1, which passes the measuring signal to a directional coupling means 3 in one position and to a directional coupling means 4 in the other position. The directional coupling means 3 and 4 are connected to the antenna line 2 in such a way that the directional coupling means 3 directs the measuring signal to be transmitted through the antenna line in the direction of the antenna, and the directional coupling means 4 directs the measuring signal to be transmitted through the antenna line in the direction of the receiver.

One output of the branching device 6 is connected to a measuring unit 8, which measures the magnitude of the measuring signal coming from the branching device. In the preferred embodiment of the invention, the measuring unit 8 also controls the change-over switch S1. The measuring unit may be e.g. a powermeter with an associated logic circuitry for the required control and calculation operations. The measuring can also be carried out by means of a field magnitude meter possibly already existing in the device. The measuring device used is preferably arranged to measure within a narrow bandwidth exactly at the measuring signal frequency.

When the condition of the antenna 1 is measured, the switch S1 passes the measuring signal from the signal generator 10 to the directional coupling means 4, which directs the measuring signal in the direction of the receiver, whereby it proceeds through the amplifier 5 and the branching device 6 to the measuring unit 8, which measures the magnitude or power of the signal and stores the measured value for subsequent use as a reference value. Thereafter the state of the switch S1 is changed, and so the measuring signal is passed to the directional coupling means 3, which directs the measuring signal through the antenna line 2 to the antenna 1. A measuring signal component reflected from the antenna 1 back to the antenna line 2 passes through both directional coupling means 3 and 4, the amplifier 5 and the branching device 6 to the measuring unit 8, which again measures the value of the magnitude of the reflected signal. Thereafter the measuring unit 8 calculates the relative difference between the reference value and the reflected signal magnitude. The relative value so obtained is compared with a preset alarm limit; if the alarm limit is exceeded, the measuring unit gives an alarm in a suitable manner.

The figure and the description related to it are only intended to illustrate the present invention. In their details, the method and the device of the present invention may vary within the scope of the attached claims.

## Claims

1. A method of supervising the condition of a receiving antenna (1), comprising the steps of
generating a radio-frequency measuring signal,
transmitting said radio-frequency measuring signal through an antenna line (2) connected to the receiving antenna in the direction of the receiving antenna (1),
measuring the magnitude of a measuring signal component reflected back from the receiving antenna (1) and propagated over a predetermined measuring signal path,
directly transmitting said radio-frequency measuring signal through the antenna line (2) in the direction of the point of measurement,
measuring a magnitude of said directly transmitted measuring signal, and
determining the condition of the receiving antenna (1) on the basis of a comparison of the two measured signal magnitudes,
characterized in that:
the predetermined measuring signal path is the path between the point on the antenna line (2) from where said radio frequency signal is directly transmitted in the direction of the point of measurement and that point of measurement, and in that
the step of measuring a magnitude of said directly transmitted measuring signal consists of measuring the magnitude of said directly transmitted measuring signal propagated over said measuring signal path, and in that
the determination of the condition of the receiving antenna (1) is based on the relative difference between the two measured signal magnitudes.

2. Method according to claim 1, characterized in that the measurements are carried out by means of a field magnitude meter of a receiver interconnected with the receiving antenna (1) by means of the antenna line (2).

3. Device for supervising the condition of a receiving antenna, comprising
a generating means (9, 10) for generating a radio-frequency measuring signal,
a first directional coupling means (3) for applying the measuring signal to an antenna line (2) connected to the receiving antenna in the direction of the receiving antenna (1),
a second directional coupling means (4) for applying the measuring signal directly in the direction of a measuring means (8),
a measuring means (8) for measuring the magnitude of a measuring signal component reflected from the antenna (1) and propagated over a predetermined measuring signal path, and for measuring the magnitude of said directly transmitted measuring signal, and for determining the condition of the receiving antenna on the basis of a comparison of the two measured signal magnitudes,
characterized in that
the second directional coupling means (4) is adapted to apply the measuring signal to the antenna line (2) and in that
the device comprises a switch means (S1) for switching the measuring signal from the generating means (9, 10) between the first directional coupling means and second directional coupling means, and in that
the switch means, first directional coupling means, second directional coupling means, and the measuring means are arranged such that the directly transmitted measuring signal and the measuring signal component reflected from the antenna (1) propagate over the same predetermined measuring signal path, and in that the predetermined measuring signal path is the path between the point on the antenna line (2) where the second directional coupling means (4) is connected to the antenna line (2) and the measuring means (8), and in that
the measuring means (8) determines the condition of the receiving antenna (1) on the basis of the relative difference between the two measured signal magnitudes.

4. Device according to claim 3, characterized by the receiving antenna (1) being interconnected to an associated receiver by means of the antenna line (2), and
a branching device means (6) coupled to the antenna line (2) before the receiver for branching a portion of the signal coming from the direction of the receiving antenna (1) to the measuring means (8).

5. Device according to claim 4, characterized in that the frequency of the measuring signal is outside the frequency band of the receiver.

## Patentansprüche

1. Verfahren zum Überwachen des Zustandes einer Empfangsantenne (1), das folgende Schritte aufweist:
- Erzeugen eines Funkfrequenz-Meßsignals,
- Senden des Funkfrequenz-Meßsignals durch eine Antennenleitung (2), die mit der Empfangsantenne verbunden ist, in Richtung der Empfangsantenne (1),
- Messen des Wertes einer Meßsignalkomponente, die von der Empfangsantenne (1) zurück reflektiert worden ist und sich über eine vorgegebene Meßsignalstrecke ausgebreitet hat,
- direktes Senden des Funkfrequenz-Meßsignals durch die Antennenleitung (2) in Richtung des Meßpunktes,
- Messen eines Wertes des direkt gesendeten Meßsignals und
- Bestimmen des Zustandes der Empfangsantenne (1) auf der Basis eines Vergleiches der zwei gemessenen Signalwerte,
dadurch gekennzeichnet,
daß die vorgegebene Meßsignalstrecke die Strecke zwischen der Stelle an der Antennenleitung (2), von der das Funkfrequenzsignal direkt in Richtung des Meßpunktes gesendet wird, und dem Meßpunkt ist,
daß der Schritt des Messens eines Wertes des direkt gesendeten Meßsignals aus dem Messen des Wertes des direkt gesendeten Meßsignals besteht, das sich über die Meßsignalstrecke ausgebreitet hat,
und daß die Betimmung des Zustandes der Empfangsantenne (1) auf der relativen Differenz zwischen den zwei gemessenen Signalwerten basiert.

2. Verfahren nach Anspruch 1,
dadurch gekennzeichnet,
daß die Messungen mit Hilfe eines Feldwertmeßgerätes eines Empfängers durchgeführt werden, der mittels der Antennenleitung (2) mit der Empfangsantenne (1) verbunden ist.

3. Vorrichtung zum Überwachen des Zustandes einer Empfangsantenne, die folgendes aufweist:
- eine Generatoreinrichtung (9, 10) zum Erzeugen eines Funkfrequenz-Meßsignals,
- eine erste Richtungskopplungseinrichtung (3) zum Anlegen des Meßsignals an eine Antennenleitung (2), die mit der Empfangsantenne verbunden ist, in der Richtung der Empfangsantenne (1),
- eine zweite Richtungskopplungseinrichtung (4) zum Anlegen des Meßsignals direkt in der Richtung einer Meßeinrichtung (8),
- eine Meßeinrichtung (8) zum Messen des Wertes einer Meßsignalkomponente, die von der Antenne (1) reflektiert wird und sich über eine vorgegebene Meßsignalstrecke ausgebreitet hat, und zum Messen des Wertes des direkt gesendeten Meßsignals und zum Bestimmen des Zustandes der Empfangsantenne auf der Basis eines Vergleichs der zwei gemessenen Signalwerte,
dadurch gekennzeichnet,
daß die zweite Richtungskopplungseinrichtung (4) dazu ausgelegt ist, das Meßsignal an die Antennenleitung (2) anzulegen,
daß die Vorrichtung eine Schalteinrichtung (S1) aufweist, um das Meßsignal von der Generatoreinrichtung (9, 10) zwischen der ersten Richtungskopplungseinrichtung und der zweiten Richtungskopplungseinrichtung umzuschalten,
und daß die Schalteinrichtung, die erste Richtungskopplungseinrichtung, die zweite Richtungskopplungseinrichtung und die Meßeinrichtung derart angeordnet sind, daß das direkt gesendete Meßsignal und die von der Antenne (1) reflektierte Meßsignalkomponente sich über die gleiche vorgegebene Meßsignalstrecke ausbreiten,
daß die vorgegebene Meßsignalstrecke die Strecke zwischen der Stelle an der Antennenleitung (2), an der die zweite Richtungskopplungseinrichtung (4) mit der Antennenleitung (2) verbunden ist, und der Meßeinrichtung (8) ist,
und daß die Meßeinrichtung (8) den Zustand der Empfangsantenne (1) auf der Basis der relativen Differenz zwischen den beiden gemessenen Signalwerten bestimmt.

4. Vorrichtung nach Anspruch 3,
dadurch gekennzeichnet,
daß die Empfangsantenne (1) mittels der Antennenleitung (2) an einen zugeordneten Empfänger angeschlossen ist und daß eine Verzweigungseinrichtung (6) vor dem Empfänger an die Antennenleitung (2) angeschlossen ist, um einen Teil des Signals, das aus der Richtung der Empfangsantenne (1) kommt, zu der Meßeinrichtung (8) abzuzweigen.

5. Vorrichtung nach Anspruch 4,
dadurch gekennzeichnet,
daß die Frequenz des Meßsignals außerhalb des Frequenzbandes des Empfängers liegt.

## Revendications

1. Procédé de contrôle de l'état d'une antenne réceptrice (1), comprenant les étapes consistant à
générer un signal de mesure de radiofréquence,
émettre dans la direction de l'antenne réceptrice ledit signal de mesure de radiofréquence par l'intermédiaire d'un câble (2) d'antenne relié à l'antenne réceptrice,
mesurer la valeur d'une composante de signal de mesure renvoyée par l'antenne réceptrice (1) et se propageant sur un circuit prédéterminé de signal de mesure,
émettre directement dans la direction du point de mesure ledit signal de mesure de radiofréquence via le câble (2) d'antenne,
mesurer la puissance dudit signal de mesure émis directement, et
déterminer l'état de l'antenne réceptrice (1) sur la base d'une comparaison des deux puissances de signal mesurées,
caractérisé en ce que:
le circuit prédéterminé de signal de mesure est le circuit entre le point du câble (2) d'antenne depuis lequel ledit signal de radiofréquence est émis directement dans la direction du point de mesure et ce point de mesure, et en ce que
l'étape consistant à mesurer une valeur dudit signal de mesure directement émis consiste à mesurer la valeur dudit signal de mesure directement émis qui s'est propagé sur ledit circuit de signal de mesure, et en ce que
la détermination de l'état de l'antenne réceptrice (1) s'effectue sur la base de la différence relative entre les deux valeurs de signal mesurées.

2. Procédé selon la revendication 1, caractérisé en ce que les mesures sont effectuées à l'aide d'un système de mesure d'intensité de champ d'un récepteur relié à l'antenne réceptrice (1) par l'intermédiaire du câble (2) d'antenne.

3. Dispositif pour contrôler l'état d'une antenne réceptrice, comprenant
un moyen générateur (9, 10) pour générer un signal de mesure de radiofréquence,
un premier moyen de couplage directif (3) pour appliquer, dans la direction de l'antenne réceptrice (1), le signal de mesure à un câble (2) d'antenne relié à l'antenne réceptrice,
un second moyen de couplage directif (4) pour appliquer directement le signal de mesure dans la direction d'un moyen de mesure (8),
un moyen de mesure (8) pour mesurer la valeur d'une composante de signal de mesure renvoyée par l'antenne (1) et se propageant sur un circuit prédéterminé de signal de mesure, et pour mesurer la valeur dudit signal de mesure directement émis, et pour déterminer l'état de l'antenne réceptrice sur la base d'une comparaison des deux valeurs de signal mesurées,
caractérisé en ce que
le second moyen de couplage directif (4) est apte à appliquer le signal de mesure au câble (2) d'antenne, et en ce que
le dispositif comporte un moyen de commutation (S1) pour commuter le signal de mesure produit par le moyen générateur (9, 10) entre le premier moyen de couplage directif et le second moyen de couplage directif, et en ce que
le moyen de commutation, le premier moyen de couplage directif, le second moyen de couplage directif et le moyen de mesure sont agencés de façon que le signal de mesure directement émis et la composante de signal de mesure envoyée par l'antenne (1) se propagent sur le même circuit prédéterminé de signal de mesure, et en ce que
le circuit prédéterminé de signal de mesure est le circuit entre le point du câble (2) d'antenne où le second moyen de couplage directif (4) est relié au câble (2) d'antenne et au moyen de mesure (8), et en ce que
le moyen de mesure (8) détermine l'état de l'antenne réceptrice (1) sur la base de la différence relative entre les deux valeurs de signal mesurées.

4. Dispositif selon la revendication 3, caractérisé en ce que l'antenne réceptrice (1) est reliée à un récepteur correspondant par l'intermédiaire du câble (2) d'antenne, et
un moyen formant dispositif de dérivation (6) couplé au câble (2) d'antenne avant le récepteur pour dériver vers le moyen de mesure (8) une partie du signal provenant de la direction de l'antenne réceptrice (1).

5. Dispositif selon la revendication 4, caractérisé en ce que la fréquence du signal de mesure est en dehors de la bande de fréquence du récepteur.
